Europäisches Patentamt

European Patent Office

Office européen des brevets

(19)

(11) Veröffentlichungsnummer: **0 412 566 A2**

# (12) EUROPÄISCHE PATENTANMELDUNG

(21) Anmeldenummer: 90115415.3

(22) Anmeldetag: **10.08.90**

(51) Int. Cl.5: **H03F 3/45**

(30) Priorität: **10.08.89 DE 3926522**

(43) Veröffentlichungstag der Anmeldung:
**13.02.91 Patentblatt 91/07**

(84) Benannte Vertragsstaaten:
**DE FR GB IT NL**

(71) Anmelder: **Siemens Aktiengesellschaft**
**Wittelsbacherplatz 2**
**D-8000 München 2(DE)**

(72) Erfinder: **Barré, Claude, Dipl.-Ing.**
**Implerstrasse 23**
**D-8000 München 70(DE)**

(54) **Integrierbarer Differenzverstärker.**

(57) Ein integrierbarer Differenzverstärker besteht aus einem ersten und einem zweiten Verstärkerast mit jeweils einem CMOS-Inverter, der in Serie zwischen zwei Stromquellen-Feldeffekttransistoren (Q11, Q12 bzw. Q21, Q22) geschaltet ist. Die Gate-Elektroden (G) der Stromquellen-Feldeffekttransistoren sind miteinander verbunden und an den Mittelabgriff des im ersten Verstärkerast angeordneten CMOS-Inverters angeschlossen. Durch Dimensionierung der verwendeten Transistoren kann eine äußerst geringe Gleichtaktverstärkung des Differenzverstärkers erzielt werden.

FIG.2

## INTEGRIERBARER DIFFERENZVERSTÄRKER

Die Erfindung betrifft einen integrierbaren Differenzverstärker gemäß dem Oberbegriff des Patentanspruchs 1.

Der Differenzverstärker als eine der an sich bedeutendsten Transistorgrundschaltungen ist in unterschiedlichsten Ausführungsformen sowohl in der Analog- als auch in der Digitaltechnik anzutreffen. Differenzverstärker können mit Bipolar- oder mit Feldeffekttransistoren realisiert werden, wobei sich letztere aus Gründen einer einfacheren Integrierbarkeit für hochintegrierte Schaltungen besser eignen.

Vom Prinzip her besteht ein Differenzverstärker aus zwei symmetrisch ausgebildeten Gleichspannungsverstärkern, die aus einer gemeinsamen Konstantstromquelle versorgt werden. In manchen Schaltungsvarianten wird die Konstantstromquelle durch einen sogenannten Stromspiegel aus zwei Gate- bzw. Basis-gekoppelten Transistoren ersetzt.

Auch die gemeinsame Anwendung einer Konstantstromquelle und zweier als Stromspiegel geschalteter Transistoren in einem Differenzverstärker ist bekannt. In FIG 12 der US-PS 48 06 877 ist eine solche Schaltung dargestellt. Die Transistoren $TR_2$, $TR_2{}'$ arbeiten als Stromquellen in Stromspiegelschaltung und die Transistoren $TR_1$, $TR_1{}'$ arbeiten als Steuerungs-Feldeffekttransistoren. Zusätzlich werden die beiden Verstärkeräste gemeinsam aus der Konstantstromquelle J1 gespeist.

Grundlagenkenntnisse über Differenzverstärker und Stromspiegelschaltungen können aus der einschlägigen Fachliteratur, z.B. Halbleiterschaltungstechnik, U. Tietze, CH. Schenk, 9. Auflage, Springer Verlag 1989, Seiten 62 bis 76 und Seiten 94 bis 99, erworben werden.

Abweichend von einem idealen Differenzverstärker, der lediglich nur die Differenz zweier Eingangsspannungen verstärkt, weisen die in der Praxis realisierbaren Differenzverstärker zwei Verstärkungskomponenten auf, nämlich die erwünschte Differenzverstärkung und eine in der Regel als unerwünscht angesehene sogenannte Gleichtaktverstärkung. Die Gleichtaktverstärkung zeigt sich darin, daß sich die Ausgangsspannung des Differenzverstärkers ändert, wenn beide Eingangsspannungen gleichermaßen um ein- und denselben Spannungswert verändert werden.

Aufgabe der vorliegenden Erfindung ist es, einen Differenzverstärker nach dem Oberbegriff des Patentanspruchs 1 so weiterzubilden, daß durch Dimensionierung der verwendeten Transistoren eine äußerst geringe Gleichtaktverstärkung erzielt werden kann.

Gelöst wird die Aufgabe erfindungsgemäß durch die im kennzeichnenden Teil des Patenanspruchs 1 angegebenen Merkmale.

Der Erfindung liegt die Erkenntnis zugrunde, daß der in bekannten Differenzverstärkern verwendete, aus zwei Gate-gekoppelten Feldeffekttransistoren bestehende Stromspiegel auf Grund der Stromabhängigkeit der Drain-Source-Spannung kein ideales Verhalten aufweist, und dadurch die Verstärkungsfaktoren der beiden Verstärkereingänge bezogen auf den Differenzverstärkerausgang voneinander abweichen.

Ein wesentlicher Vorteil eines erfindungsgemäß ausgebildeten Differenzverstärkers besteht darin, daß der Schaltungsaufbau für eine Dimensionierung der Transistoren so viele Freiheitsgrade bietet, daß die Verstärkungsfaktoren der beiden Verstärkereingänge angeglichen werden können, ohne daß sich andere Arbeitspunkte, wie z.B. die Schaltschwellen verschieben.

Vorteilhafte Ausbildungen der Erfindung sind in den Unteransprüchen angegeben.

Mit weiteren Stromquellentransistoren wird der Differenzverstärker vorteilhafterweise symmetrisch ausgebildet, wodurch zwei Polaritätsvarianten, wie beim bekannten Differenzverstärker, nicht mehr erforderlich sind.

Anhand der Zeichnung werden im folgenden zwei Ausführungsbeispiele der Erfindung näher erläutert.

Dabei zeigen

FIG 1 einen bekannten Differenzverstärker in zwei Polaritätsvarianten,

FIG 2 einen erfindungsgemäß ausgebildeten Differenzverstärker mit in Serie geschalteten Stromquellentransistoren,

FIG 3 einen erfindungsgemäß ausgebildeten Differenzverstärker mit parallelgeschalteten Stromquellentransistoren.

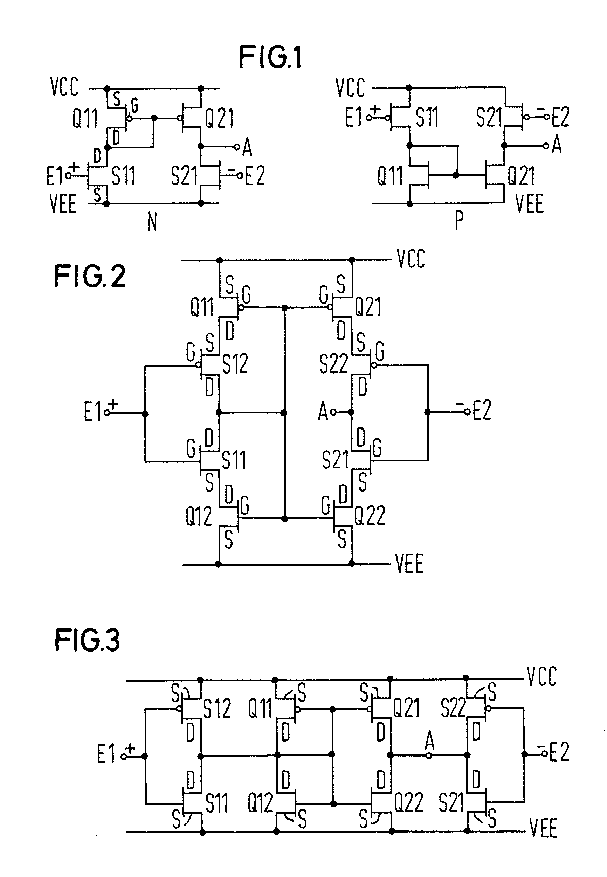

In der FIG 1 sind zwei Schaltbilder für die beiden Polaritätsvarianten des bekannten Differenzverstärkers dargestellt. In beiden Varianten setzt sich der Differenzverstärker aus einem ersten und einem zweiten Verstärkerast zusammen, die jeweils aus einer Serienschaltung eines Stromquellentransistors und eines Steuerungstransistors bestehen. Zur Bildung eines Stromspiegels sind die Stromquellentransistoren an ihren Gateelektroden G miteinander verbunden. Der Stromquellentransistor im ersten Verstärkerast ist mit seiner Drainelektrode D, die eine Verbindung zu den Gateelektroden aufweist, als Stromspiegeleingang ausgebildet. Die Drainelektrode des Stromquellentransistors im zweiten Verstärkerast bildet sowohl den Stromspiegelausgang wie auch den Differenzverstärkerausgang A.

Bei der ersten Variante N des Differenzverstärkers (linkes Schaltbild) sind in den beiden Verstärkerästen jeweils ein als PMOS-Feldeffekttransistor, abgekürzt PMOS-FET, ausgebildeter Stromquellentransistor Q11, Q21 in Serie mit einem als NMOS-Feldeffekttransistor, abgekürzt NMOS-FET, ausgebildeten Steuerungstransistor S11, S21 geschaltet. Der Stromquellentransistor Q 11 und der Steuerungstransistor S 11 sind an ihren Drainelektroden D miteinander verbunden. Entsprechend sind die Drainelektroden des Stromquellentransistors Q 21 und des Steuerungstransistors S 21 miteinander verbunden. An ihren Sourceelektroden S sind die Stromquellentransistoren an ein Spannungspotential VCC (z.B. + 5 Volt) und die Steuerungstransistoren an ein gegenüber dem Spannungspotential VCC negativeres weiteres Spannungspotential VEE (z.B. 0 Volt) angeschlossen.

Die Gateelektroden G der Steuerungstransistoren S11, S21 sind als Differenzverstärkereingänge ausgebildet, wobei die Gate-elektrode G des im ersten Verstärkerast befindlichen Steuerungstransistors S11 als positiver Differenzverstärkereingang E1 und die Gateelektrode des im zweiten Verstärkerast angeordneten Steuerungstransistors S21 als negativer Differenzverstärkereingang E2 bezeichnet wird.

Die zweite Variante P des bekannten Differenzverstärkers (rechtes Schaltbild) unterscheidet sich von der ersten Variante N lediglich dadurch, daß die Steuerungstransistoren S11, S21 als PMOS-FETs und die Stromquellentransistoren Q11, Q21 als NMOS-FETs ausgebildet und an das Spannungspotential VCC bzw. das weitere Spannungspotential VEE angeschlossen sind.

In der FIG 2 ist ein Schaltbild eines erfindungsgemäß ausgebildeten Differenzverstärkers dargestellt, bei dem die Verstärkeräste jeweils einen aus Steuerungstransistoren S11, S12; S21, S22 bestehenden CMOS-Inverter aufweisen, der in Serie zwischen zwei Stromquellentransistoren Q11, Q12; Q21, Q22 geschaltet ist.

Der CMOS-Inverter eines jeden Verstärkerastes besteht jeweils aus einem als NMOS-FET ausgebildeten Steuerungstransistor S11, S21 und einem als PMOS-FET ausgebildeten weiteren Steuerungstransistor S12, S22. Die Transistoren S11 und S12 sowie die Transistoren S21 u. S22 sind miteinander sowohl über ihre Drainelektroden D als auch über ihre Gateelektroden G verbunden. Die Gateelektroden bilden einen jeweiligen Differenzverstärkereingang E1, E2 und die Drainelektroden des im zweiten Verstärkerast angeordneten CMOS-Inverters den Differenzverstärkerausgang A.

In beiden Verstärkerästen ist der weitere Steuerungstransistor S12, S22 mit seiner Sourceelektrode S über die Drain-Source- Strecke eines als PMOS-FET ausgebildeten Stromquellentransistors Q11, Q21 an ein Spannungspotential VCC (z.B. 5 Volt), und der steuerungstransistor S11, S21 über einen als NMOS-FET ausgebildeten weiteren Stromquellentransistor Q12, Q22 an ein gegenüber dem Spannungspotential VCC negativeres weiteres Spannungspotential VEE (z.B. 0 Volt) angeschlossen. Die Gateelektroden sämtlicher Stromquellentransistoren Q11, Q12, Q21, Q22 des Differenzverstärkers sind miteinander verbunden und an die, einen Mittelabgriff des CMOS-Inverters bildenden Drainanschlüsse der im ersten Verstärkerast befindlichen Steuerungstransistoren S11, S12 angeschlossen.

Geht man von einer einheitlichen Transistor-Dimensionierung aus, bei der die Stromquellen und Steuerungstransistoren des ersten Verstärkerastes zu den entsprechenden Stromquellen bzw. Steuerungstransistoren des zweiten Verstärkerastes gleich groß ausgebildet sind, und bei der das Größenverhältnis zwischen P-und NMOS-FETs für alle Steuerungs- und Stromquellentransistoren gleich ist, so würde ein Differenzverstärker vorliegen, bei dem, wie beim bekannten Differenzverstärker, der Verstärkungsfaktor vom positiven Verstärkereingang E1 zum Verstärkerausgang A betragsmäßig kleiner ist, als der Verstärkungsfaktor vom negativen Verstärkereingang E2 zum Verstärkerausgang A. Dieser auf Grund der Stromabhängigkeit der Drain-Source-Spannungen sich bildende Unterschied der Verstärkungsfaktoren stellt die Ursache für die Gleichtaktverstärkungskomponente des bekannten Differenzverstärkers dar.

Beim erfindungsgemäß ausgebildeten Differenzverstärker ist es nun möglich, durch eine Dimensionierung der Transistoren die beiden Verstärkungsfaktoren voneinander unabhängig und ohne Beeinflussung sonstiger Arbeitspunkte zu verändern.

Werden z.B. die beiden Stromquellentransistoren Q11, Q12 im ersten Verstärkerast gleichermaßen um einen gemeinsamen Faktor größer ausgebildet (d.h. der Innenwiderstand wird dadurch kleiner), so erhöht sich der Verstärkungsfaktor vom positiven Eingang E1 zum Verstärkerausgang A, ohne daß dadurch der Verstärkungsfaktor vom negativen Eingang E2 zum Verstärkerausgang A beeinflußt wird. Dies liegt daran, daß die durch den CMOS-Verstärker gebildete treibende Komponente gegenüber der durch die Sromquellentransistoren gebildeten Rückkopplungskomponente im ersten Verstärkerast größer wird.

Allgemein kann man sagen, daß unter Beibehaltung des Größenverhältnisses zwischen P- und NMOS-Feldeffekttransistoren der Verstärkungsfaktor eines jeweiligen Verstärkereinganges dadurch erhöht bzw. verringert werden kann, daß in dem zugehorigen Verstärkerast das Größenverhältnis zwischen Steuerungs- und Stromquellentransistoren verändert wird.

In der FIG 3 ist ein Schaltbild für einen erfindungsgemäß ausgebildeten Differenzverstärker mit zu den, einen CMOS-Inverter bildenden Steuerungstransistoren parallelgeschalteten Stromquellentransistoren dargestellt.

Der erfindungsgemäß ausgebildete Differenzverstärker setzt sich ebenfalls aus einem ersten und einem zweiten Verstärkerast zusammen. In beiden Verstärkerästen ist jeweils ein als NMOS-FET ausgebildeter steuerungstransistor S11, S21 und ein als PMOS-FET ausgebildeter weiterer Steuerungstransistor S12, S22 vorgesehen. Die Drain- und Gateelektroden D, G der Transistoren S11, S12 sind miteinander zur Bildung eines CMOS-Inverters verbunden. Entsprechend sind die Drain- und Gateelektroden D, G der Transistoren S21, S22 zur Bildung eines weiteren CMOS-Inverters miteinander verbunden. Die Sourceelektrode S des Steuerungstransistors S11, S21 ist an ein weiteres Spannungspotential VEE (z.B. 0 Volt), die Sourceelektrode S des weiteren Steuerungstransistors S12, S22 an ein positiveres Spannungspotential VCC (z.B. 5 Volt) geschlossen. Weiterhin sind in beiden Verstärkerästen jeweils ein als PMOS-FET ausgebildeter Stromquellentransistor Q11 bzw. Q21 und ein als NMOS-FET ausgebildeter weiterer Stromquellentransistor Q12 bzw. Q22 über ihre Drain- und Gateelektroden D, G miteinander verbunden und mit ihren Sourceelektroden S an das Spannungspotential VCC bzw. das weitere Spannungspotential VEE angeschlossen.

Die Gateelektroden der Steuerungstransistoren S12, S11 des ersten Verstärkerastes bilden den positiven Verstärkereingang E1, die Gateelektroden der Steuerungstransistoren S21, S22 des zweiten Verstärkerastes bilden den negativen Verstärkereingang E2.

Sämtliche Stromquellentransistoren Q11, Q12, Q21, Q22 des Differenzverstärkers sind an ihren Gateelektroden miteinander verbunden und an die Drainelektroden der im ersten Verstärkerast angeordneten Steuerungstransistoren S11, S12 und Stromquellentransistoren Q11, Q12 angeschlossen. Im zweiten Verstärkerast sind die Drainelektroden der Steuerungstransistoren S21, S22 und der Stromquellentransistoren Q21, Q22 miteiandner verbunden und bilden den Verstärkerausgang A.

Auch bei diesem Differenzverstärker lassen sich die Verstärkungsfaktoren der Verstärkereingänge voneinander unabhängig verändern. Dazu muß für den, dem jeweiligen Verstärkereingang zugehörigen Verstärkerast das Größenverhältnis zwischen Steuerungs- und Stromquellentransistoren verändert werden. Dabei führt jedoch eine Verkleinerung der Stromquellentransistoren zu einer Erhöhung des dem betreffenden Verstärkereingang zugehörigen Verstärkungsfaktors.

## Ansprüche

1. Integrierbarer Differenzverstärker mit einem ersten und einem zweiten Verstärkerast, die jeweils einen mit seiner Drain-Source-Strecke an ein Spannungspotential (VCC) angeschlossenen Stromquellen-Feldeffekttransistor (Q11, Q21) und einen zu diesem komplementär ausgebildeten Steuerungs-Feldeffekttransistor (S11, S21) aufweisen, dessen Drain-Source-Strecke zur Bildung eines Strompfades zwischen dem Stromquellen-FET (Q11, Q21) und einem weiteren Spannungspotential (VEE) dient, und dessen Gateelektrode zu einem, dem jeweiligen Verstärkerast zugeordneten Verstärkereingang ausgebildet ist, sowie mit einem im Strompfad zwischen Stromquellen-FET (Q11, Q21) und Steuerungs-FET (S11, S21) vorgesehenen Mittelabgriff, der beim ersten Verstärkerast mit den Gateelektroden beider Stromquellen-FETs (Q11, Q21) verbunden ist, und beim zweiten Verstärkerast als Verstärkerausgang (A) ausgebildet ist, **dadurch gekennzeichnet,** daß die Verstärkeräste jeweils einen zum Steuerungs-FET (S11, S21) komplementär ausgebildeten weiteren Steuerungs-FET (S12, S22) aufweisen, der mit dem Steuerungs-FET (S11, S21) zu einem den Mittelabgriff bildenden CMOS-Inverter verbunden ist.

2. Integrierbarer Differenzverstärker nach Anspruch 1, **dadurch gekennzeichnet,** daß die Verstärkeräste jeweils einen zum Stromquellen-FET (Q11, Q21) komplementär ausgebildeten weiteren Stromquellen-FET (Q12, Q22) aufweisen, dessen Gateelektrode mit der des Stromquellen-FETs (Q11, Q21) verbunden ist, und dessen Drain-Source-Strecke in Serie mit der des Stromquellen-FETs (Q11, Q21) geschaltet ist.

3. Differenzverstärker nach Anspruch 2, **dadurch gekennzeichnet,** daß der CMOS-Inverter über je einen der Stromquellen-FETs (Q11, Q12; Q21, Q22) an die Spannungspotentiale (VCC, VEE) angeschlossen ist.

4. Differenzverstärker nach Anspruch 2, **dadurch gekennzeichnet,** daß die Drain-Source-Strecken des Stromquellen-FETs (Q11, Q21) und des weiteren Steuerungs-FETs (S12, S22) parallelgeschaltet sind, und daß die Drain-Source-Strecken des Steuerungs-FETs (S11, S21) und des weiteren Stromquellen-FETs (Q12, Q22) parallelgeschaltet und an das weitere Spannungspotential (VEE) angeschlossen sind.

# FIG.1

# FIG.2

# FIG.3